# EUROPEAN PATENT APPLICATION

(11) **EP 1 378 347 A1**
(43) Date of publication of application: **07.01.2004**
(21) Application number: 02254608.9
(22) Date of filing: 01.07.2002
(51) Int. Cl.: B32B 18/00, H01L 23/538, H01L 21/48

(54) **Method for reducing shrinkage during sintering low-temperature ceramic**

(71) Applicant: Yageo Corporation, Hsin-Tien, Taipei Taiwan ROC (TW)
(72) Inventor: Lee, Wen-Hsi, c/o Phycomp Taiwan, Ltd., Processing Zone, Koahsiung (TW); Su, Che-Yi, c/o Phycomp Taiwan, Ltd., Processing Zone, Koahsiung (TW); Lee, Chun-Te, c/o Phycomp Taiwan, Ltd., Processing Zone, Koahsiung (TW); Jao, Jui-Chu, c/o Phycomp Taiwan, Ltd., Processing Zone, Koahsiung (TW)
(74) Representative: Nicholls, Michael John

(57) **Abstract**

The present invention mainly relates to a method for reducing X-Y shrinkage during sintering low temperature ceramic comprising piling a constrain layer on a dielectric layer on a green ceramic body, which is printed with heterogeneous materials for conductors, resistors, capacitors and the like and/or disposed conductors, resistors, capacitors and the like to reduce shrinkage of the dielectric layer and the green ceramic body. The invention is characterized in that the constrain layer comprises windows in positions complying with the heterogeneous materials and/or conductors, resistors, capacitors and the like printed and/or disposed on the dielectric layer and the green ceramic body to make the heterogeneous materials and/or conductors, resistors, capacitors and the like not being covered when piling the constrain layer and the dielectric layers of the green ceramic body.

## Description

The present invention relates to a method for reducing shrinkage during sintering low-temperature ceramic by means of applying a constrain layer with windows. The present invention avoids removal of the constrain layer after firing and damage to the surface flatness of ceramic in conventional technologies, and also simplifies the process procedures to lower the cost. Therefore, a multilayer ceramic in high quality is produced by the invention.

Interconnect circuit boards are necessary for modem electronic products to meet the requirement of being light, thin and small. The interconnect circuit boards are either electronic circuits interconnecting each other electrically or mechanically, or subsystems from a number of extremely small circuit elements combined in an arrangement. Such circuit elements can be physically isolated and mounted adjacent to one another in a single interconnect circuit board to electrically connect to each other and/or extend from the interconnect circuit board thereby.

In the interconnect circuit board, complex electronic circuits generally require that several insulating dielectric layers be used to separate layers of conductors. The electrically conductive pathways interconnecting conductive layers through the dielectric are called vias. Such a multiplayer structure allows a circuit to be more compact and occupy less space.

Among various methods for making a multilayer circuit, the method described in U.S. Patent No. 4,654,095 is by co-firing a multiplicity of ceramic tape dielectrics on which heterogeneous materials for resistors, capacitors, or conductors have been printed with metallized vias extending through the dielectric layers to interconnect various conductive layers. The dielectric layers are stacked in registry and pressed together at a proper temperature and pressure, and then fired to drive off the organics such as binders and plasticizers in the green ceramic body. All the ceramic and heterogeneous materials are sintered and densified thereby. This method has the advantages of performing firing only once, saving fabricating time and labor, and limiting the diffusion of mobile metals to prevent shorting between the conductive layers. However, because the shrinkages of elements in sintering is not the same, the firing condition is difficult to control. Furthermore, this X-Y dimensional uncertainty resulting in misregistration during assembly of large and complex circuits is particularly undesirable.

Nowadays, almost all shrinkages are controlled in the Z-direction to reduce X-Y dimensional shrinkage. Such processes are disclosed in U.S. Patent No. 5,085,720 (E. I. Du Pont de Nemours and Company) and U.S. Patent No. 5,130,067 (International Business Machines Corporation), which are incorporated herein as references.

In U.S. Patent No. 5,085,720, the top and bottom of the green ceramic body each are applied with a release layer to form a "sandwich" structure. During burning out and sintering, a unidirectional pressure is applied to the surface of the release layer. The porosity of the release layer provides an escape pathway for the volatile components of the green ceramic body. Because the release layer does not shrink in firing, the X-Y shrinkage of the green ceramic body is reduced. However, the release layers cover both the top and bottom surfaces of the green ceramic body, and their removal should be performed after sintering for printing with and firing the conductors, resistors, and capacitors thereon. The cost of the method thus rises. In addition, the penetration of the inorganic binder contained in the release layer into the green body, and the contact angle, the viscosity, the porosity and the pore size of the release layer all affect the flatness of the ceramic surface during the removal of the release layer, and are easy to make the circuit printing difficult and the products defective. When fabricating a large number of ceramic layers (e.g. more than 6 layers), middle layers of a green ceramic body still shrink as the result of the forces not being distributed evenly by applying the release layers on the top and bottom of the green body (i.e. the forces on the top and the bottom and on the middle layers of the green body are substantially different).

U.S. Patent No. 5,130,067 has described three approaches to reduce X-Y shrinkage of a green ceramic body. With the first approach, constraint is applied to the outer edges of the green ceramic body to provide an open escape path for volatiles and an entry path for oxygen. With the second approach, a co-extensive force is applied to the entire surface of the green ceramic body by either using a co-extensive porous platen or by application of an air-bearing force to the surface. With the third approach, a frictional force is applied to the green body by use of a porous contact sheet which does not shrink or expand during firing. The contact sheet comprises a porous composition selected so that it remains porous during firing, does not fuse to the ceramic, is thermally stable and has continuous mechanical integrity/rigidity. The contact sheet maintains its dimensions during sintering and thus restricts the ceramic part from shrinking. After sintering, the contact sheet is removed by means of an appropriate removal procedure, such as polishing and scraping which will not damage the surface of the ceramic. However, the three approaches described above have disadvantages. For example, the first approach easily leads to shrinkage of the ceramic and further affects shape of the circuit and flatness of the ceramic surface because it uses a weight produced by a fixture to reduce the shrinkage and the pressure distributes unevenly on the green ceramic body. The second and third approaches need removal steps after firing, and the cost increases and the surfaces are damaged also.

In order to resolve the problems mentioned above, the present invention develops a novel method for reducing shrinkage during sintering low-temperature ceramic to save cost and improve quality of the ceramic product.

The present invention mainly relates to a method for reducing X-Y shrinkage during sintering low temperature ceramic comprising piling a constrain layer on a dielectric layer printed with heterogeneous materials for conductors, resistors, capacitors and the like to reduce shrinkage of the dielectric layer and the green ceramic body formed therefrom. The invention is characterized in that the constrain layer comprises windows in positions complying with the heterogeneous materials for conductors, resistors, capacitors and the like printed and/or conductors, resistors, capacitors and the like printed and/or disposed on the dielectric layer of a green ceramic body to make the heterogeneous materials and/or conductors, resistors, capacitors and the like not being covered when piling the constrain layer(s) and the dielectric layers to form a green ceramic body; wherein a shortest length of the constrain layer is L; a radius of a circumscribed circle of each window is c; a distance between the adjacent circumscribed circles is a; a distance between the most outside window and an edge of the constrain layer is b, c<0.5L, a>0.1c, b>0.1c.

In another aspect, the present invention relates to a method for reducing shrinkage during sintering low-temperature ceramic comprising piling a constrain layer on a dielectric layer printed with heterogeneous materials to reduce shrinkage of the dielectric layer and the green ceramic body, wherein the constrain layer comprises windows in positions complying with the heterogeneous materials for conductors, resistors, capacitors and the like printed and/or conductors, resistors, capacitors and the like printed/disposed on the dielectric layer of a green ceramic body, and the dielectric layer and/or the constrain layer comprises bonding glass, or a bonding glass layer is applied between the dielectric layer and the constrain layer.

The present invention also relates to a method for reducing shrinkage during sintering low-temperature ceramic comprising piling a constrain layer on a dielectric layer printed with heterogeneous materials to reduce shrinkage of the dielectric layer of a green ceramic body, wherein the constrain layer comprises windows in positions complying with the heterogeneous materials for conductors, resistors, capacitors and the like printed and/or conductors, resistors, capacitors and the like printed/disposed on the dielectric layer, and after piling the dielectric layers and the constrain layer(s) to form a green ceramic body, a Z-directional force is applied during firing.

The present invention is also directed to a constrain layer for use in reducing shrinkage of a dielectric layer or a green ceramic body printed with heterogeneous materials, comprising windows in positions complying with the heterogeneous materials to make the heterogeneous materials not being covered when piling the constrain layer(s) and the dielectric layers of the green ceramic body; wherein a shortest length of the constrain layer is L; a radius of a circumscribed circle of each window is c; a distance between the adjacent circumscribed circles is a; a distance between the most outside window and an edge of the constrain layer is b, c<0.5L, a>0.1 c, b>0.1 c.

The invention will be further described by way of example with reference to the accompanying drawings, in which:-
FIG. 1 illustrates the constrain layer according to an embodiment of the invention, wherein L is a shortest length of the constrain layer; c is a radius of a circumscribed circle of each window; a is a distance between the adjacent circumscribed circles; and b is a distance between the most outside window and an edge of the constrain layer;
FIG. 2 illustrates a plot of temperature of a high sintering temperature constrain layer and low-temperature ceramic versus shrinkage rate; and
FIG. 3 illustrates a plot of temperature of a low sintering temperature constrain layer and low-temperature ceramic versus shrinkage rate.

The present invention provides a method for reducing shrinkage during sintering low-temperature ceramic, which is preferably applied for fabricating ceramic multilayer circuits using conventional conductive metallizations, including conductors, resistors and the like. The method of the invention reduces dimensional uncertainty in ceramic structures and eliminates dimensional errors and misregistration.

The dielectric layer and the green ceramic body of the invention may be prepared by any conventional manner known in the art, and for example, is made of an admixture of finely divided particles of ceramic solids and sinterable inorganic binder dispersed in a volatilizable solid polymeric binder. In the process of firing, after volatilization of the polymeric binders, the inorganic components of the green ceramic body start sintering when heated to an adequate temperature. During sintering, the particulate-porous green ceramic body undergoes changes in its structure including an increase in grain size and a change of pore shape, size and number. Sintering unusually produces a decrease in porosity and results in densification of the particulate compact.

The present invention comprises piling a constrain layer on a dielectric layer printed with heterogeneous materials for conductors, resistors, capacitors and the like to reduce shrinkage of the dielectric layers and of a green ceramic body, preferably, piling constrain layers on both the top and the bottom of the ceramic body, to form a monolithic structure. The invention is characterized in that the constrain layer comprises windows in positions complying with the heterogeneous materials for conductors, resistors, capacitors and the like printed and/or conductors, resistors, capacitors and the like printed and/or disposed on the dielectric layer or the green ceramic body.

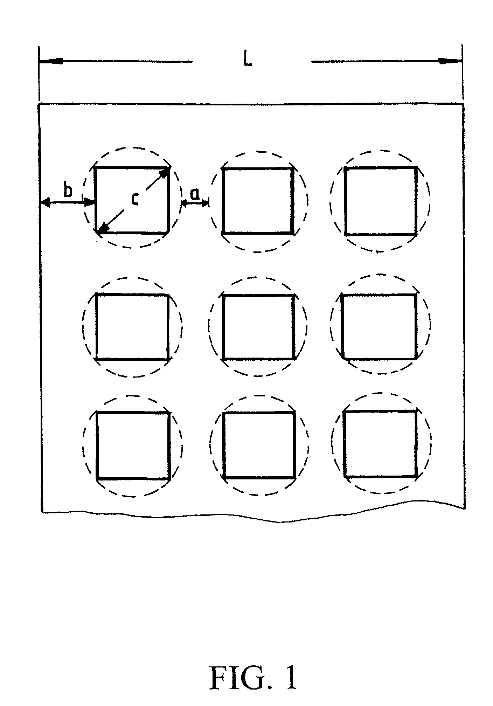

Referring to FIG.1, a constrain layer with the shortest length L is punched to form windows thereon. The windows can be in any shape in a circumscribed circle with a radius c, a distance between the adjacent circumscribed circles is a, and a distance between the most outside window and an edge of the constrain layer is b, c<0.5L, a>0.1c, b>0.1c. In the invention, radiuses of each circumscribed circle can be different, provided that the windows in positions comply with the heterogeneous materials for conductors, resistors, capacitors and the like printed and/or on the dielectric layer and the green ceramic body to make the heterogeneous materials and/or conductors, resistors, capacitors and the like not be covered when piling the constrain layer(s) and the dielectric layers to form a green ceramic body. A thickness of the constrain layer (L₁) is related to a thickness of the green ceramic body (L₂) disposed between the two constrain layers. If the ratio of L₂/L₁ is less than about 3.1, the shrinkage rate can be less than about 0.5%. One or more constrain layers can also be applied between dielectric layers of the green ceramic body, in addition to on the top and the bottom of the monolithic structure when a large layer number of ceramic is fabricated to keep dielectric layers of ceramic from shrinking. The dielectric layers and the constrain layers are piled/laminated in the way of a constrain layer - (a single layer or multiple dielectric layers - a constrain layer - a single layer or multiple dielectric layers)ₙ - a constrain layer to form a green ceramic body; wherein n is an integer. The thickness of the constrain layer applied between dielectric layers of the green ceramic body is not less than a thickness of the heterogeneous materials, conductors, resistors, capacitors and the like printed on the dielectric layers (L₃), preferably L₁=L₃ to enhance the evenness of the monolithic structure.

In accordance with the method of the present invention, bonding glass can be used whether or not a pressure is applied during firing. Conventional method of applying the unidirectional pressure normal to the exposed surface of the constrain layer used in this field is suitable for the invention. The pressure is sufficient for the constrain layer to contact the dielectric layer and the green ceramic body, and substantially results in all shrinkage occurring in the Z-direction normal to the monolithic structure. That is, the X-Y dimension of the dielectric layer and the green ceramic body does not shrink during firing. The bonding glass should be used when no pressure is applied. The bonding glass can be added into the materials of the constrain layer and/or the dielectric layer (or green ceramic body) directly, or be in form of a bonding glass layer presented between the constrain layer and the dielectric layer (or green ceramic body). When adding into the material of the constrain layer directly, the amount of the bonding glass should not be either too high to lead the constrain layer to shrinking, or too low to not provide binding effect. The constrain layer comprises about 1% to about 10% of bonding glass, preferably about 1% to about 6%. Taking adding borosilicate glass in an aluminum oxide (Al₂O₃) constrain layer as an example, the preferable amount of the borosilicate glass is between about 1% to about 10 % by weight, based on the total weight of borosilicate glass and aluminum oxide. When a bonding glass is applied on a surface of the dielectric layer, the bonding glass preferably does not cover regions printed/disposed with heterogeneous materials, conductors, resistors, capacitors or the like. The bonding glass layer is prepared by dissolving glass particles in a proper solvent as an ink, and printed on the dielectric layer, the green ceramic body or the constrain layer, or added between the dielectric layer (or green ceramic body) and the constrain layer by coating directly, spotter deposition or vapor deposition. Furthermore, the bonding glass (layer) can be used when the pressure is applied. Different bonding glasses can be selected, depending on the process need.

The method of the invention can be used to fabricate ceramic circuits either with or without a prefired refractory substrate backing. The backing may or may not be metallized. In the case of metallized, it may or may not be prefired. If a substrate backing is used, the green ceramic body is placed on the substrate backing, followed by the constrain layer. The entire assemblage is then placed in the constraining die or press for firing. If a substrate backing is not used, a constrain layer is placed on both the top and the bottom of the green ceramic body.

The present invention has many advantages: (1) Because no shrinkage occurring in the X-Y dimension of the constrain layer, the shrinkage of the monolithic structure is inhibited or reduced by the presence of bonding glass or application of the pressure. (2) The constrain layer needs not be removed after firing so that it completely avoids damages occurring on the surface of the dielectric layer (or green ceramic body), which are resulted from removing the porous contact sheet or the release layer in the prior art. The surface of the ceramic manufactured by the method of the invention is very smooth (Surface roughness Ra.0.2µm). The fabricated capacitors, resistors or flip-chip integrated circuit is more precise in size. The cost of removal is avoided thereby. (3) The windows on the constrain layer can provide escape pathways for the gas when firing the green ceramic body. (4) The pollution resulted from the green ceramic body contacting the die is prevented because of the use of the constrain layer to isolate the green ceramic body from the die. (5) A high layer number of ceramic product can be fabricated by applying constrain layers with windows between dielectric layers of the green ceramic body. (6) The conductors and electric elements can be directly printed on the dielectric layer and the green ceramic body to be fired.

### Ceramic Solids

The composition of the ceramic solids in the green ceramic body used in the invention may be any conventional one. The composition itself is not directly critical so long as the solids are chemically inert with respect to the other materials in the system and have the following physical properties relative to other components of the green ceramic body: (1) they have sintering temperatures well above the sintering temperatures of the inorganic binder, and (2) they do not undergo sintering during the firing step of the invention. The examples of the ceramic solids include inorganic metals, usually metal oxides, and any high melting inorganic solids, and high softening point glasses. Moreover, the ceramic solids may be chosen on the basis of both its dielectric and thermal expansion properties. Thus, mixtures of such materials may be selected in order to match the thermal expansion characteristics of any substrate to which they are applied.

### Inorganic Binder

The composition of the inorganic binder in the invention may be any conventional one. It is chemically inert with respect to the other materials in the system and has the following appropriate physical properties: (1) it has a sintering temperature well below that of the ceramic solids; and (2) it undergoes viscous phase sintering at the firing temperatures used. The inorganic binder suitable for the invention is usually glass, particularly crystallized or non-crystallized glass in firing.

### Polymeric Binder

The inorganic bonder and ceramic solids are dispersed in the polymeric binder. The polymeric binder optionally has dissolved therein other materials such as plasticizers, release agents, dispersing agents, stripping agents, antifouling agents and wetting agents. Any polymeric binder known in the art for producing low-temperature ceramic is suitable to be used in the present invention.

### Green Ceramic Body

Any conventional green ceramic body may be used in the invention. For example, the green ceramic body is formed from low dielectric layers made of the ceramic solids, inorganic binder and polymeric binder, on which heterogeneous for conductors, resistors, capacitors and the like have been printed and/or conductors, resistors, capacitors and the like have been printed and/or disposed with metallized vias extending through the dielectric layers to interconnect various conductive layers. The green ceramic body generally comprises a glass and ceramic system and a glass-ceramic system.

The main component of the glass and ceramic system is aluminum oxide (Al₂O₃). For the purpose of lowering sintering temperature of aluminum oxide and maintaining high frequency of the whole system, glass component, comprising K₂O, B₂O₃, SiO₂, CaO, BaO, SrO or V₂O₅ and the mixture thereof, is usually added.

The main component of the glass-ceramic system is a series of Mg-AlSi and Ca-AlSi materials which are ceramic crystals produced by heating non-crystalline of the glass.

### Constrain Layer

The constrain layer is made of any materials that reduce shrinkage of the dielectric layer and the green ceramic body during sintering. The constrain layer comprises a high sintering temperature constrain layer and a low sintering temperature constrain layer.

### (1) High sintering temperature constrain layer:

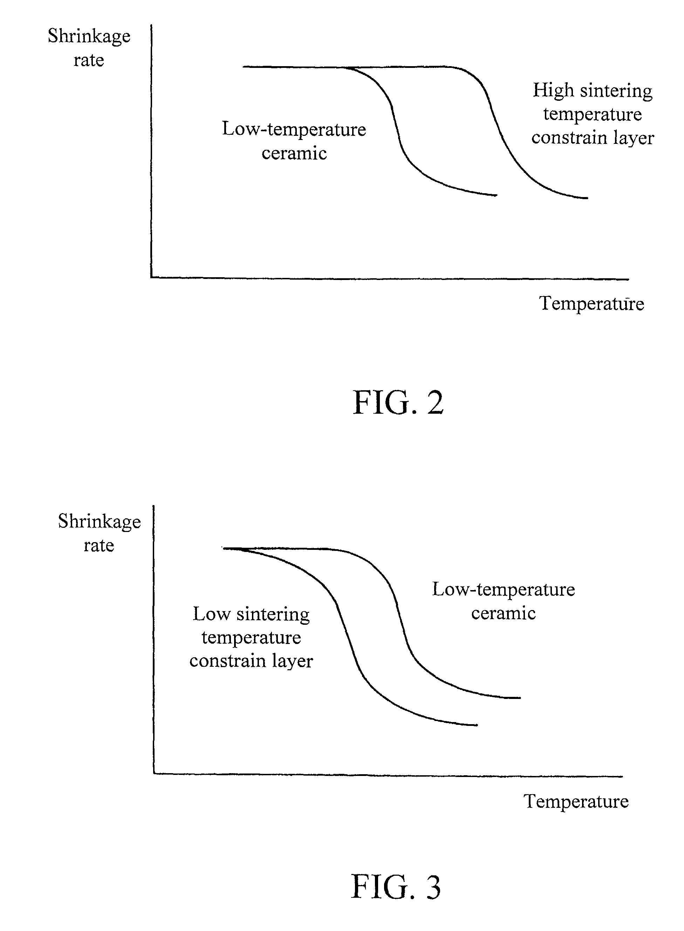

A high sintering temperature constrain layer comprises ceramic tapes such as aluminum oxide (sintering at a temperature .1400.) (referring to FIG. 2). A common low dielectric, low-temperature ceramic sinters at about 900□. At a temperature at which the low-temperature ceramic starts to sinter, the high sintering temperature constrain layer does not shrink because its sintering temperature is higher and is not reached yet. It takes the advantage that the high sintering temperature constrain layer does not shrink in the X-Y dimension at about 900. so as to inhibit and reduce X-Y dimension shrinkage of the low-temperature ceramic. The high sintering temperature constrain layer may be, for example, the release layer in U.S. Patent No. 5,085,720 which comprises finely divided particles of non-metallic particles dispersed in a volatilizable organic medium. However, when the release layer is used in the invention, the penetration of the inorganic binder and the contact angle of the release layer need not be considered, and the removal step after firing is also not necessary. The contact sheet in U.S. Patent No. 5,130,067 can also be used in the present invention as the high sintering temperature constrain layer, which includes a porous green sheet of alumina, glass, or non-crystallizing glass/ceramic.

### (2) Low sintering temperature constrain layer:

Being different from the high sintering temperature constrain layer described in (1), a low sintering temperature constrain layer is added with a strong auxiliary component to lower the sintering temperature of the constrain layer (referring to FIG. 3). That is, before the low-temperature ceramic starts to sinter, the low sintering temperature constrain layer has completed its sintering. When the low sintering temperature constrain layer starts to sinter, its X-Y shrinkage is inhibited and reduced by the low-temperature ceramic which does not shrink at this temperature range. At this moment the role of the high sintering temperature constrain layer as stated in (1) is assumed by the low-temperature ceramic. When the temperature is raised to where the low-temperature ceramic starts to sinter, the low sintering temperature constrain layer has completed its sintering and does not shrink any more and thus the X-Y shrinkage of the low-temperature ceramic is inhibited and reduced thereby. For example, taking aluminum oxide as the low sintering temperature constrain layer, the strong auxiliary component may be vanadium oxide or other component, preferably the amount of vanadium oxide is about 1% to about 10 % by weight.

The constrain layer is preferably made of porous materials. Not only can the windows of the constrain layer provide escape pathways of the green ceramic body for volatile gas during firing, but the pores of the porous materials also can. As previously described, the constrain layer can also be added between dielectric layers of the green ceramic body, in addition to on the upper and the bottom of the green ceramic body. Because the constrain layer does not shrink during sintering, it inhibits and reduces the X-Y shrinkage of the green ceramic body and the dielectric layers contained therein by bonding result from the bonding glass between the constrain layer and the dielectric layer (or green ceramic body) or by applying pressure.

### Bonding Glass

In the present invention, the bonding glass is optionally added between the dielectric layer (or green ceramic body) and the constrain layer for bonding. Preferably, the bonding glass is added on a surface of the constrain layer with windows and then applies the constrain layer on the dielectric layer (or green ceramic body), so that the amount of bonding glass is reduced and the bonding glass will not contact the heterogeneous material, conductors, resistors, capacitors and the like on the dielectric layer (or green ceramic body). Therefore, whether or not the bonding glass reacts with the dielectric layer (or green ceramic body) or the constrain layer is not important in the invention. During sintering, partial bonding glass melts and diffuses into the dielectric layer (or green ceramic body) to bond the constrain layer and the dielectric layer (or green ceramic body).

### Methods

In general, a method for reducing shrinkage during sintering low-temperature ceramic in the invention comprises:
(a) providing a dielectric layer or a green ceramic body and a constrain layer by filling their respective components into separate jars and adding water to maintain the amount of solids of about 60 % to about 70 % by weight, wherein the components are ground to average particle size of about 0.9 to about 0.7 µm, and an organic bonding agent (e.g. polyvinyl acetate (PVA)) and a plasticizer (e.g. polyethylene glycol (PEG)) are further added to form the dielectric layer, the green ceramic body or the constrain layer by passing the cast slurry under a blade;
(b1) punching windows on the constrain layer with a shortest length L wherein a radius of a circumscribed circle of each window is c; a distance between the adjacent circumscribed circles is a; a distance between the most outside window and an edge of the constrain layer is b, c<0.5L, a>0.1c, b>0.1c;
(b2) printing heterogeneous materials for conductors, resistors, capacitors and the like on the dielectric layer (or green ceramic body) and/or optionally adding conductors, resistors, capacitors or the like; wherein the windows of the constrain layer are in positions complying with the heterogeneous materials printed and/or conductors, resistors, capacitors and the like printed and/or disposed on the dielectric layer and the green ceramic body to make the heterogeneous materials and/or conductors, resistors, capacitors and the like not being covered when piling the constrain layer(s) and the dielectric layers of the green ceramic body;
(c) applying bonding glass on a surface of the dielectric layer (or green ceramic body) preferably not covering regions printed with heterogeneous material, conductors, resistors, capacitors or the like, or on a surface of the constrain layer by printing, coating directly, spotter depositing or vapor depositing;
(d) piling the dielectric layers and the constrain layer(s) to form a green ceramic body in a monolithic structure, wherein ways of piling may be a constrain layer - (a single dielectric layer or multiple dielectric layers) of the green ceramic body - a constrain layer - (a single dielectric layer or multiple dielectric layers) of the green ceramic body - a constrain layer; wherein a amount of the dielectric layers of the green ceramic body is about 40 % to about 60 % by weight, based on the total weight of the green ceramic body (including the constrain layer(s)); such a structure can improve the uniformity, and the number of dielectric layers to be fired is unlimited; when fabricating multilayer ceramic circuits, a dielectric layer without any heterogeneous materials, conductors, resistors, capacitors or the like can be used on the top and/or the bottom of the green ceramic body as cover layers, and the constrain layer is then applied to form a monolithic structure;
(e) applying a Z-direction pressure;
(f) firing the monolithic structure at a temperature and for a time sufficient to effect volatilization of the polymeric binders from both the green ceramic body and the constrain layer; wherein, for example, the monolithic structure is fired at about 300 to about 350 . for about 24 to about 38 hours to remove the inorganic binder and then sintered at about 850 to about 920 . for about 30 minutes to about 4 hours;
(g) optionally cooling the monolithic structure;
(h) optionally printing with ink of resistors, capacitors or the like on the outer surface of the green ceramic body; and
(i) optionally cutting according to the circuit printed;
wherein steps (c) and (e) are applied either or both.

The ceramic made according to the present invention can be coated/applied with a nickel/tin layer and then disposed with an integrated circuit, a multilayer ceramic circuit, a resistor SMD on the surface. The yield is then determined.

In another aspect, the present invention is also directed to a constrain layer for use in reducing shrinkage of a dielectric layer printed with heterogeneous materials for conductors, resistors, capacitors and the like, and/or printed/disposed conductors, resistors, capacitors and the like. The constrain layer is piled/laminated on the dielectric layer, and comprises windows in positions complying with the heterogeneous materials for conductors, resistors, capacitors and the like printed and/or conductors, resistors, capacitors and the like printed/disposed on the dielectric layer to make the heterogeneous materials and/or conductors, resistors, capacitors and the like not be covered when piling the constrain layer(s) and the dielectric layers to form a green ceramic body; wherein a shortest length of the constrain layer is L; a radius of a circumscribed circle of each window is c; a distance between the adjacent circumscribed circles is a; a distance between the most outside window and an edge of the constrain layer is b, c<0.5 L, a>0.1 c, b>0.1 c.

### Example 1

Material components of a dielectric layer or a green ceramic body (Ca-AlSi) or those of a constrain layer (aluminum oxide and borosilicate glass) were filled into two jars and water was added to maintain the amount of solids to about 65 % by weight. The components were ground to average particle size of about 0.8 µm. PVA an organic bonding agent and PEG a plasticizers were further added to form a dielectric layer or a green ceramic body with a thickness of about 80 µm, and the constrain layer with a thickness of L1 by passing the cast slurry under a blade. In this example, the windows were formed by directly punching the constrain layer. Positions of the windows complied with the regions printed with electrodes; wherein each window was a 1 cm × 1 cm square, a distance between each window was 0.65 cm and a distance between the most outside window and an edge of the constrain layer was 1.2 cm.

The dielectric layer was printed with a circuit to form a conductive layer. The dielectric layers and the constrain layer were laminated piled in the way of a constrain layer - multiple dielectric layers of the green ceramic body - a constrain layer. The total thickness of dielectric layers of the green ceramic body was L₂.

Firing conditions used in this example were at about 300. for about 24 to about 38 hours for removing the inorganic binder, and then at about 880, for about 30 minutes. The sample was then cooled and cut directly according to the circuits printed.

Results of X-Y shrinkage of the green ceramic body under different values of L₁ and L₂ were measured and listed in Table 1:

**Table 1:**

| L₂/L 1 | X-Y shrinkage rate (%) |
|---|---|
| 0.0 | 0.1 |
| 3.1 | 0.5 |
| 4.4 | 0.8 |
| 4.8 | 1.0 |
| 6.4 | 1.6 |
| 6.6 | 1.4 |
| 11.0 | 3.8 |

### Example 2

The procedures of Example 1 were followed for Example 2 to obtain a green ceramic body with a thickness of about 300.m and constrain layers with thickness of about 145.m and about 10.m.

The dielectric layers and the constrain layers were laminated in the way of a constrain layer (145.m) - (m+1) dielectric layers and m constrain layers (10.m) alternated - a dielectric layer green ceramic - a constrain layer (145.m) to form the green ceramic body.

Results of X-Y shrinkage of the green ceramic body under different values of m were measured and listed in Table 2:

**Table 2**

| m | X-Y shrinkage rate (%) |
|---|---|
| 0 | 1.84 |
| 1 | 1.77 |
| 2 | 1.69 |

### Example 3

The procedures of Example 1 were followed for Example 3 to obtain a green ceramic body with a thickness of about 800.m and a constrain layer with thickness of about 250.m. The constrain layer comprised n % of borosilicate glass.
Results of X-Y shrinkage of the green ceramic body under different values of n were measured and listed in Table 3:

**Table 3:**

| N | X-Y shrinkage rate (%) |
|---|---|
| 0 | 0.68 |
| 2 | 0.28 |

While embodiments of the present invention have been illustrated and described, various modifications and improvements can be made by persons skilled in the art. The embodiments of the present invention are therefore described in an illustrative but not restrictive sense. It is intended that the present invention is not limited to the particular forms as illustrated, and that all the modifications not departing from the spirit and scope of the present invention are within the scope as defined in the appended claims.

## Claims

1. A method for reducing X-Y shrinkage during sintering low temperature ceramic comprising piling a constrain layer on a dielectric layer printed with heterogeneous materials to reduce shrinkage of the dielectric layer and of a green ceramic body, which is **characterized in that** the constrain layer comprises windows in positions complying with the heterogeneous materials printed and/or conductors, resistors, capacitors and the like printed and/or disposed on the dielectric layer to make the heterogeneous materials and/or conductors, resistors, capacitors and the like not being covered when piling the constrain layer(s) and the dielectric layers to form a green ceramic body; wherein a shortest length of the constrain layer is L; a radius of a circumscribed circle of each window is c; a distance between the adjacent circumscribed circles is a; a distance between the most outside window and an edge of the constrain layer is b, c<0. SL, a>0.1c, b>0.1c.

2. A method according to Claim 1, wherein bonding glass is applied between the dielectric layer and the constrain layer, or between the green ceramic body and the constrain layer.

3. A method according to Claim 2, wherein the bonding glass comprises borosilicate glass.

4. A method according to Claim 1, wherein the dielectric layer, the green ceramic body and/or the constrain layer comprises bonding glass.

5. A method according to Claim 4, wherein the constrain layer comprises about 1 % to about 10 % of bonding glass.

6. A method according to Claim 4, wherein the constrain layer comprises about 1 % to about 6 % of bonding glass.

7. A method according to Claim 1, wherein the constrain layer is a high sintering temperature constrain layer with a sintering temperature higher than that of the green ceramic body.

8. A method according to Claim 7, wherein the high sintering temperature constrain layer comprises Al₂O₃.

9. A method according to Claim 1, wherein the constrain layer is a low sintering temperature constrain layer with a sintering temperature lower than that of the green ceramic body.

10. A method according to Claim 9, wherein the low sintering temperature constrain layer comprises about 1 % to about 10 % of a strong auxiliary component to lower the sintering temperature of the constrain layer.

11. A method according to Claim 10, wherein the strong auxiliary component is vanadium oxide.

12. A method according to any one of the preceding claims, wherein the constrain layer is applied on the bottom of the dielectric layer or the green ceramic body.

13. A method according to Claim 12, wherein a ratio (L₂/L₁) of a total thickness of the green ceramic body (L₁) and a thickness of the constrain layer (L₂) is less than about 3.5.

14. A method according to Claim 12 or 13, wherein a dielectric layer without heterogeneous materials is applied between the dielectric layers with heterogeneous materials and the constrain layer of the green ceramic body.

15. A method according to any one of the preceding claims, wherein a Z-direction of pressure is applied during firing.

16. A method according to any one of the preceding claims, wherein the piling is in the way of a constrain layer - (a single layer or multiple dielectric layers - a constrain layer - a single layer or multiple dielectric layers)ₙ - a constrain layer to form the green ceramic body; wherein n is an integer.

17. A method according to any one of the preceding claims, wherein a thickness of the constrain layer (L₁) is not less than a thickness of the heterogeneous materials, conductors, circuits, capacitors or the like printed on the dielectric layers of the green ceramic body (L₃).

18. A method according to Claim 17, wherein L₁= L₃.

19. A method according to any one of the preceding claims, wherein a amount of the dielectric layers of the green ceramic body is about 40 % to about 60 % by weight, based on the total weight of the green ceramic body (including the constrain layer(s))

20. A constrain layer for use in reducing shrinkage of a dielectric layer printed with heterogeneous materials, comprising windows in positions complying with the heterogeneous materials printed on the dielectric layer to make the heterogeneous materials not be covered when piling the constrain layer(s) and the dielectric layers to form a green ceramic body; wherein a shortest length of the constrain layer is L; a radius of a circumscribed circle of each window is c; a distance between the adjacent circumscribed circles is a; a distance between the most outside window and an edge of the constrain layer is b, c<0.5L, a>0.1c, b>0.1c.
